# EUROPEAN PATENT APPLICATION

(11) **EP 1 750 286 A1**
(43) Date of publication of application: **07.02.2007**
(21) Application number: 06253936.6
(22) Date of filing: 27.07.2006
(51) Int. Cl.: H01B 1/22

(54) **Conductor composition for use in LTCC photosensitive tape on substrate applications**

(30) Priority: 28.07.2005 US 703530 P; 20.07.2006 US 490011 P
(71) Applicant: E.I. du Pont de Nemours and Company, Wilmington, DE 19898 (US)
(72) Inventor: Nair, Kumaran Manikantan, Head of the Harbor, New York 11780-1232 (US); McCombs, Mark Frederick, Clayton, North Carolina 27520 (US)
(74) Representative: Towler, Philip Dean

(57) **Abstract**

The present invention is directed to a thick film conductor composition comprising: (a) 70 to 98 weight percent of one or more electrically functional powders; (b) 0.5 to 10 weight percent glass frit; (c) 0.5 to 6 weight percent inorganic borides; dispersed in (d) organic medium, based on total thick film composition. The composition is useful as a via fill and/or innerlayer conductor composition in PTOS applications.

## Description

### FIELD OF THE INVENTION

The present invention relates to a thick film conductor composition useful in photosensitive tape on substrate (PTOS) applications. In particular, one embodiment of the invention relates to the use of said conductor composition as a via fill used in forming a ceramic multilayer circuit by the PTOS method.

### BACKGROUND OF THE INVENTION

While the present invention may be useful in a multitude of applications such as, electronic circuits in general, multilayer ceramic interconnect circuit boards, pressure sensors, fuel cells, customization of ceramic objects, and the creation of fired patterned art work, it is especially useful in the manufacture of multilayer interconnect circuit boards. The background of the invention is described below with reference to ceramic interconnect circuit boards, as a specific example of the prior art.

An interconnect circuit board is a physical realization of electronic circuits or subsystems made from a number of small circuit elements that are electrically and mechanically interconnected. It is frequently desirable to combine these diverse type electronic components in an arrangement so that they can be physically isolated and mounted adjacent to one another in a single compact package and electrically connected to each other and/or to common connections extending from the package.

Complex electronic circuits generally require that the circuit be constructed of several layers of conductors separated by insulating dielectric layers. The conductive layers are interconnected between levels by electrically conductive pathways, called vias, through a dielectric layer. Such a multilayer structure allows a circuit to be more compact and have denser circuit functionality.

One well-known method for constructing a multilayer interconnect circuit is by sequentially printing and firing thick film conductors and insulating dielectrics through a patterned screen mesh onto a rigid ceramic insulative substrate. The rigid substrate provides mechanical support, dimensional stability, and facilitates registration of the patterned thick film conductor and dielectric layers. However, the thick film process is disadvantageous in that printing through a screen mesh can result in pinholes or voids in the dielectric layer which can cause shorting between conductor layers. If the thick film dielectric is formulated to allow sufficient flow of the paste during the printing operation and thus to minimize the tendency to form pinholes, then the maintenance of small vias is likely to be compromised by the flow of dielectric paste into the via hole. Also, the repetitive printing and firing steps for each layer are time consuming and expensive.

Another method for constructing multilayer interconnect circuits employs thick film conductors and green dielectric sheets comprising inorganic dielectric powders dispersed in an organic polymer binder. Vias are formed in the individual sheets by mechanical punching or laser drilling. The dielectric sheets containing vias are laminated in registry to a dimensionally stable insulative substrate on which a conductor pattern has been formed and the dielectric is fired. Next the vias are metallized and a second conductor layer is formed on the exposed surface of the dielectric layer in registry with the vias. The sequential steps of adding dielectric tape layers and metallizations and firing (i.e., each layer is fired before application of the next layer) are repeated until the desired circuit is obtained. Processes utilizing green dielectric sheets sequentially laminated by conventional press lamination methods to dimensionally stable substrates are further described in U.S. Patent Nos. 4,655,864 and U.S. 4,654,552. Using dielectric in sheet form avoids the printing and flow drawbacks of the thick film paste dielectric. But, via formation by mechanical and laser means is time consuming, as well as expensive. Also, registration of the via arrays in the different sheets is difficult and the mechanical punch stresses and deforms the sheet surrounding the via.

EP 0589241 to Suess et al. discloses a photosensitive ceramic dielectric sheet composition and the manufacture of multilayer interconnect circuits using said sheet. The sheet is self-supporting and developable in a dilute aqueous solution of Na₂CO₃. The composition of Suess et al. teaches that a "small amount of plasticizer, relative to the binder polymer, serves to lower the glass transition temperature (Tg) of the binder polymer, and furthermore, that the use of such materials should be minimized in order to reduce the amount of organic materials which must be removed when the films cast therefrom are fired." While Suess et al. provides a photosensitive tape composition for use in multilayer interconnect circuits, it does not provide a method for high-speed manufacturing.

Furthermore, the art teaches various methods for control of xy shrinkage during the formation of multilayer circuits as described in U.S. 4,654,095 to Steinberg, U.S. 5,085,720 to Mikeska, U.S. 6,139,666 to Fasano et al., and US 6,205,032 to Shepherd et al.. However, each of these methods utilizes conventional press lamination (including uniaxial, isostatic) methods and do not allow for high speed manufacturing. Therefore, a need exists for a ceramic dielectric sheet composition which may be used in a novel high speed manufacturing method, while still controlling x,y shrinkage.

Recently, in U.S. Patent Application 10/910126 to Bidwell et al., a method of multilayer interconnect circuit manufacturing and associated compositions was developed, and termed "photosensitive tape on substrate (PTOS)," which combines the following advances including (1) high speed manufacturing method through (a) quick patterning with a via and/or circuit array after lamination, (b) superior photosensitive dielectric composition sheet (or tape) with fast development and exposure times; (c) hot roll lamination processing; (d) superior adhesion characteristics; and (e) conventional furnace firing; while (2) controlling x,y shrinkage to zero or nearly zero; (3) providing a lead-free and/or cadmium-free sheet composition; (4) providing the ability to replace functional layers if a mistake is made; and (5) providing a dielectric composition with superior dielectric properties.

Unlike other LTCC dielectric tapes and electronic circuit manufacturing methods, vias developed in PTOS applications show "undercutting" and tended to increase the via cavity size by up to 20 percent upon firing. Prior art LTCC via fill conductor compositions typically sinter and densify resulting in a decrease in the via conductor volume during firing. As a result, prior art conductor compositions when used as via fill compositions in PTOS applications tended to lose connectivity between the via conductor and the surrounding ceramics and/or lose connectivity with surface and/or inner layer conductor lines.

The inventors of the present invention have provided superior conductor thick film paste compositions, which may be used as via fill compositions, that can overcome these connectivity problems associated with prior art conductor compositions and their use in PTOS applications by maintaining the bonding of the via fill composition with the surrounding ceramics and also the bonding of the surface and inner layer conductor lines upon firing.

### SUMMARY OF THE INVENTION

The present invention is directed to a thick film conductor composition comprising: (a) 70 to 98 weight percent of one or more electrically functional powders; (b) 0.5 to 10 weight percent glass frit; (c) 0.5 to 6 weight percent inorganic borides; dispersed in (d) organic medium, based on total thick film composition. The composition is useful as a via fill and/or innerlayer conductor composition in PTOS applications.

The present invention is further directed to methods of forming and structures themselves, including electronic circuits, which comprise said composition wherein said composition has been fired to volatilize the organic medium and sinter the glass frit.

### BRIEF DESCRIPTION OF THE DRAWINGS

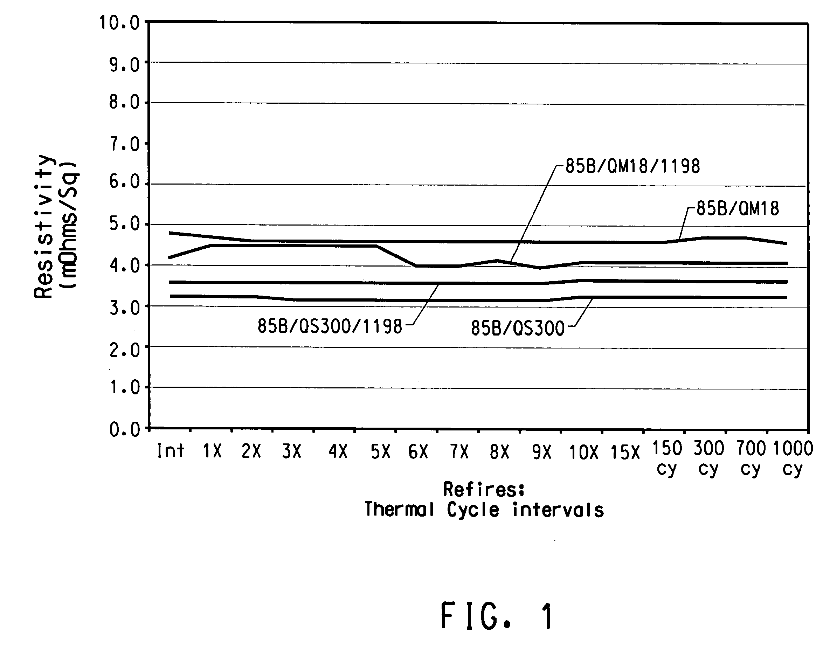

**Figure 1** is a resistivity graph detailing both multiple firing effect and the thermal cycle intervals versus resistivity for parts utilizing the conductor composition of the present invention (85B), used as a via fill composition, in combination with thick film line conductors (QM18 and QS300 available from E. I. du Pont de Nemours and Company and Delphi Electronics Product No. 1198).

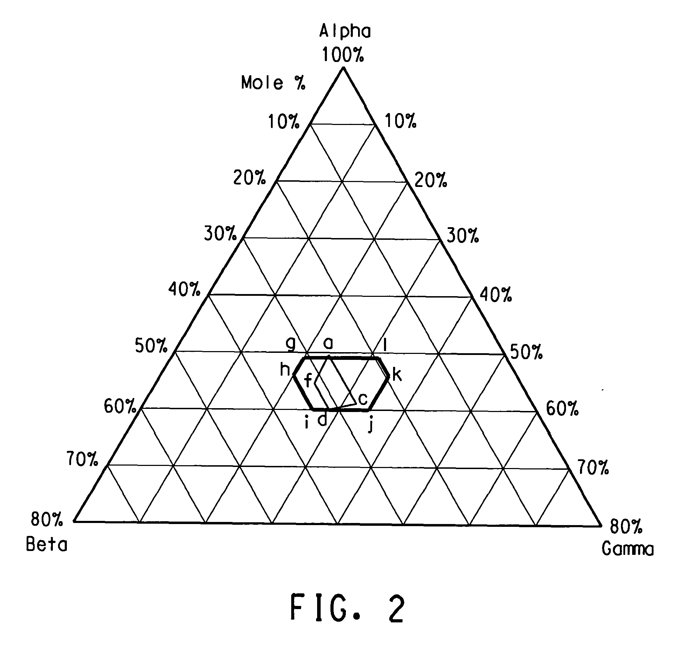

**Figure 2** is a ternary phase diagram showing the compositional range for the glass contained in the substrate of one embodiment of the present invention wherein the substrate contains a dielectric paste or tape containing CaO, MgO and/or SrO as alkaline earth modifiers.

### DETAILED DESCRIPTION OF THE INVENTION

### I. Thick Film Conductor Composition

The thick film conductor composition of the present invention comprises inorganic components and organic medium. The conductor composition is particularly useful as a thick film via fill composition. However, in some applications it may also be useful as an innerlayer conductor composition. Additionally, the composition may be utilized as both a via fill and an innerlayer composition in some applications.

The main components of the thick film conductor composition of the present invention are (1) electrically functional powders, (2) glass frit (glass composition), (3) inorganic borides, dispersed in (4) organic medium. The inorganic components of the present invention comprise (1) electrically functional powders, (2) glass frit (glass composition), and (3) inorganic borides. The inorganic binder may further comprise additional inorganic oxide binders, such as refractory inorganic oxides. The components are discussed herein below.

### A. Electrically Functional Powder

Generally, a thick film composition comprises a functional phase that imparts appropriate electrically functional properties to the composition. The functional phase comprises electrically functional powders dispersed in an organic medium that acts as a carrier for the functional phase which forms the composition. The composition is fired to burn out the organic phase, activate the inorganic binder phase and to impart the electrically functional properties. Prior to firing, the printed parts are dried to remove the volatile solvents. "Organics" is a term used to describe the polymer or resin components of a thick film composition, as well as solvents and small amounts of additional organic components such as surfactants.

The electrically functional powders in the present thick film composition are conductive powders and may comprise a single type of metal powder, mixtures of metal powders, alloys, or compounds of several elements. The particle diameter and shape of the metal powder is not particularly important as long as it is appropriate to the application method. Examples of such powders include gold, silver, platinum, palladium, and combinations thereof. The electrically functional powders of the present invention have a typical size of D₅₀ less than about 10 microns. Typically, the electrically functional powders are present in an amount of 70 to 98 weight percent total thick film composition.

### B. Glass Frit (Glass Composition)

A glass frit useful in the via fill composition of the present invention is an alumino borosilicate glass containing cations such as: Ca, Mg, Ti, Na, K, and Fe. In one embodiment, the glass frit is commercial product number E-glass such as EF/F005 from Nippon Electric Glass Co.

The particle size of the frits and oxides is not narrowly critical and materials useful in the present invention will typically have an average particle size from about 0.5 to about 15.0 µm, preferably from about 1 to 8 µm and most preferably 1 to about 4 µm.

It is preferred that the glass frit have a softening point of between about 350°C and 840°C in order that the compositions can be fired at the desired temperatures (typically 750-900°C, particularly 850°C) to effect proper sintering, wetting and adhesion to the substrate, particularly a LTCC substrate. In one embodiment, the softening point of the glass frit is in the range of 820°C to 840°C (log viscosity 7.6) and 910°C to 925°C (log viscosity 6). It is known that mixtures of high and low melting frits can be used to control the sintering characteristics of the conductive particles. One or more different glass frit compositions may be used in the present invention. The glass frit is present in the thick film composition in an amount of 0.5 to 10 weight percent total thick film composition. In one embodiment, the glass frit is present in an amount of 1 to 5 weight percent total thick film composition.

As used herein, the term "softening point" refers to softening temperatures obtained by the fiber elongation method of ASTM C338-57.

The glass binders (glass frits) are prepared by conventional glassmaking techniques, by mixing the desired components (or precursors thereof, e.g., H₃BO₃ for B₂O₃) in the desired proportions and heating the mixture to form a melt. As is well known in the art, heating is conducted to a peak temperature and for a time such that the melt becomes entirely liquid, yet gaseous evolution has ceased. The peak temperature is generally in the range 1100°C-1500°C, usually 1200°C-1400°C. The melt is then quenched by cooling the melt, typically by pouring onto a cold belt or into cold running water. Particle size reduction can then be accomplished by milling as desired.

Other transition metal oxides may also be employed as all or part of the inorganic binder. Oxides or oxide precursors of zinc, cobalt, copper, nickel, rhodium, ruthenium, titanium, manganese and iron are useful in the present invention. These additives improve adhesion.

### C. Inorganic Borides

The thick film composition of the present invention further comprises one or more inorganic borides in an amount of 0.5 to 6 weight percent total composition. Examples of such inorganic borides include, but are not limited to, borides of titanium, borides of zirconium, and mixtures thereof. It is believed that the borides will react with oxygen on firing and form either oxy-borides and/or metal oxide in close contact with boron oxide resulting higher molecular volume/ unit cell volume than that of the parent metal boride.

### D. Organic Medium

The inorganic components are typically mixed with an organic medium by mechanical mixing to form viscous compositions called "pastes", having suitable consistency and rheology for printing. A wide variety of inert liquids can be used as organic medium. The organic medium must be one in which the inorganic components are dispersible with an adequate degree of stability. The rheological properties of the medium must be such that they lend good application properties to the composition, including: stable dispersion of solids, appropriate viscosity and thixotropy for screen printing, acceptable unfired "green" strength, appropriate wettability of the substrate and the paste solids, a good drying rate, and good firing properties. The organic medium is typically a solution of polymer(s) in solvent(s). Additionally, a small amount of additives, such as surfactants, may be a part of the organic medium. The most frequently used polymer for this purpose is ethyl cellulose. Other examples of polymers include ethylhydroxyethyl cellulose, wood rosin, mixtures of ethyl cellulose and phenolic resins, polymethacrylates of lower alcohols, and monobutyl ether of ethylene glycol monoacetate can also be used. The most widely used solvents found in thick film compositions are ester alcohols and terpenes such as alpha- or beta-terpineol or mixtures thereof with other solvents such as kerosene, dibutylphthalate, butyl carbitol, butyl carbitol acetate, hexylene glycol and high boiling alcohols and alcohol esters. In addition, volatile liquids for promoting rapid hardening after application on the substrate can be included in the vehicle. Various combinations of these and other solvents are formulated to obtain the viscosity and volatility requirements desired.

The ratio of organic medium in the thick film composition to the inorganic components in the dispersion is dependent on the method of applying the paste and the kind of organic medium used, and it can vary. Usually, the dispersion will contain 70-98 weight percent of inorganic components and 2-30 wt % of organic medium (vehicle).

### E. Optional Inorganic Components

The via fill composition of the present invention may further comprise optional inorganic components, such as refractory inorganic oxides. Examples of possible optional inorganic refractory oxides include Al₂O₃, ZrO₂, TiO₂, etc. and mixtures thereof. These refractory oxides act as "sintering inhibitors."

Figure 1 details both the repeated firing effect and effect of the thermal cycle intervals versus resistivity characteristics for PTOS parts which utilize the thick film conductor composition of the present invention (as the via fill conductor identified as 85B) and other commercially available conductor compositions (Product Nos. QM18 and QS300 commercially available from E. I. du Pont de Nemours and Company, Product No. 1198 commercially available from Delphi Electronics).

### II. Photosensitive Tape on Substrate - Dielectric Tape

### Composition

The dielectric thick film tape composition and application described below are described in detail in U.S. Patent Application 10/910126 to Bidwell. The via fill thick film conductor composition of the present invention is particularly useful in PTOS applications utilizing the below identified dielectric tape composition(s).

### INORGANIC BINDER

The inorganic binder ideally should be non-reactive, but in reality, may be reactive with respect to the other materials in the system. It is selected to possess the desired electrically insulative characteristics and have the appropriate physical properties relative to any ceramic solids (fillers) in the body.

The particle size and particle size distribution of the inorganic binder and any ceramic solids are not narrowly critical, and the particles will usually be between 0.5 and 20 µm in size. The D₅₀ (median particle size) of frit is preferably in the range of, but not limited to, 1 to 10 µm and more preferably 1.5 to 5.0 µm.

The basic physical properties that are preferred for the inorganic binder are (1) that it have a sintering temperature below that of any ceramic solids in the body, and (2) that it undergo viscous phase sintering at the firing temperatures used.

The glass of the present composition is a family of amorphous, partially crystallizable alkaline earth zinc silicate glass compositions. These compositions are disclosed in U.S. Patent No. 5,210,057 to Haun et al.

Haun et al. discloses an amorphous partially crystallizable alkaline earth zinc silicate glass consisting essentially of a composition falling within the area defined on a weight points g-I of Figure 2, in which: (1) alpha is SiO₂ in admixture with a glass former or conditional glass former selected from the group consisting of no more than 3% Al₂O₃, 6% HfO₂, 4% P₂O₅, 10% TiO₂, 6% ZrO₂ and mixtures thereof, with the proviso that the composition contains at least 0.5% ZrO₂; (2) beta is an alkaline earth selected from CaO, SrO, MgO, BaO and mixtures thereof, with the proviso that the composition contain no more than 15% MgO and no more than 6% BaO; and (3) gamma is ZnO, the loci of points g-I being as follows: point g ― Alpha 48.0, Beta 32.0, Gamma 20.0; point h ― Alpha 46.0, Beta 34.0, Gamma 20.0; point i ― Alpha 40.0, Beta 34.0, Gamma 26.0; point j ― Alpha 40.0, Beta 24.0, Gamma 36.0; point k ― Alpha 46.0, Beta 18.0, Gamma 36.0; point k ― Alpha 46.0, Beta 18.0, Gamma 36.0; point l ― Alpha 48.0, Beta 19.0, Gamma 33.0.

Haun et al. further discloses the glass described in the above paragraph in which alpha contains Al₂O₃ up to 3% plus 2/3 of the % of BaO if any; and constitutes with respect to the total glass composition no more than 48% plus the % of BaO; beta contains up to 6% BaO and constitutes with respect to the total glass composition no more than 33% plus ½ of the % of BaO if any; and gamma constitutes no more than 36% minus 1/3 of the % of BaO if any.

Haun et al. further discloses the glasses described above which further contains both Al₂O₃ and P2O₅, added as AlPO₄ or AlP₃O₉.

The glass utilized in one Pb-free, Cd-free embodiment of the present invention relates to an alkali-alkaline earth-alumino- borosilicate glass composition comprising, in mole %, 46-66% SiO₂, 3-9% Al₂O₃, 5-9% B₂O₃, 0-8% MgO, 1-6% SrO, 11-22% CaO, and 2-8% M wherein M is selected from oxides of the group of alkali elements and mixtures thereof. Alkali elements are found in group IA of the periodic table. For example, the alkali element oxide may be selected from Li₂O, Na₂O, K₂O and mixtures thereof. The molar ratio of SrO / (Ca + MgO) is between about 0.06 to about 0.45. This ratio range is necessary to assure compatibility properties with conductor materials used in conjunction with the LTCC tape of this invention.

In this Pb-free and Cd-free embodiment, the content of alkali and alkaline earth modifier in the glass is believed to increase the thermal expansion coefficient of glass while providing glass viscosity reduction critical to processing LTCC tape materials. Although the alkaline earth oxide, BaO, could be used to make an LTCC tape, it is found to reduce the chemical resistance, due to its ease of leaching in low pH solutions. For this reason, superior chemical resistance is found for alkaline earth modifier constituents within the ratio limits and mole percents defined above. Strontium oxide imparts superior solderability and low conductor resistivity in conductor material systems applied to outer layers of the tape. The content of strontium oxide in the glass, provides this improved conductor performance when present in the glass at levels including and exceeding 1 mole%. Data show that levels of 1 to 6 mole% provide improved conductor performance. A preferred level of strontium oxide is 1.8 - 3.0 mole%. The existence of the alkali oxides in the glass when used in a green tape improves the sensitivity of the glass to thermal process conditions by controlling the densification and crystallization behavior of the tape. The crucial role of the alkali addition is to provide required flow and densification characteristics to the tape at a desired firing temperature. It performs the function of glass viscosity reduction without affecting required physical and electrical performance of the tape. The type and amounts of alkali ions used to modify the viscosity properties of the glass also have an effect on the electrical loss characteristics of the tape made from the glass.

The glasses described herein may contain several other oxide constituents. For instance, ZrO₂, GeO₂, and P₂O₅ maybe partially substituted for SiO₂ in the glass as follows, in mole % based on total glass composition: 0-4 mole% ZrO₂, 0-2 mole% P₂O₅, and 0-1.5 mole% GeO₂. Additionally 0-2.5 mole%, based on total glass composition, CuO may be partially substituted for the alkali and/or the alkaline earth constituents. A factor for the suitability of an LTCC tape formulation utilizing glass as a constituent is the required compatibility with conductors, and passive materials utilized as circuit components within and on the surface of the tape. This includes physical constraints such as suitable thermal expansion and the attainment of suitable levels of density and strength of the tape, the latter of which is enabled by the suitability of the glass viscosity to provide a tape in the required thermal processing temperature range.

The glasses described herein are produced by conventional glass making techniques. More particularly, the glasses may be prepared as follows. Glasses are typically prepared in 500 -1000 gram quantities. Typically, the ingredients are weighted, then mixed in the desired proportions, and heated in a bottom-loading furnace to form a melt in a platinum alloy crucible. Heating is typically conducted to a peak temperature (1500-1550°C) and for a time such that the melt becomes entirely liquid and homogeneous. The glass melts are then quenched by pouring on the surface of counter rotating stainless steel rollers to form a 10-20 mil (254-508 µm) thick platelet of glass or by pouring into a water tank. The resulting glass platelet or water quenched frit is milled to form a powder with its 50% volume distribution set between 1-5 microns. The resulting glass powders are formulated with filler and medium into thick film pastes or castable dielectric compositions.

The glass when incorporated into a tape is compatible with co-fired thick film conductor materials. The glass in the tape does not flow excessively upon firing. This is due to the partial crystallization of the glass, which is initiated by the reaction between a ceramic filler, typically Al₂O₃, and the glass. The glass, which remains following the partial crystallization, is changed to a more refractory glass. This eliminates staining of the tape with the conductor material and allows solder wetting or chemical plating of the thick film conductor material. Solder wetting is an important feature to allow connection of the ceramic circuit to external wiring such as on a printed circuit board. If chemical plating of thick film conductors is applied to surface layers of the tape, low pH plating baths can release ions from the surface of the tape contaminating the plating bath. For this reason, the glass found in the tape minimizes the release of glass constituents by chemical corrosion in reduced pH solutions. Additionally, the glass found in the tape also minimizes the release of glass constituents by chemical corrosion in strong basic solutions.

### OPTIONAL CERAMIC SOLIDS

The ceramic solids are optional in the dielectric composition of the invention. When added, they are selected to be chemically inert with respect to the other materials in the system, possess the desired electrically insulative properties and to have the appropriate physical properties relative to the inorganic binder and photosensitive components of the compositions. Basically, the solids are fillers, which adjust properties such as thermal expansion and dielectric constant.

The physical properties most desirable of the ceramic solids in the dielectric are (1) that they have sintering temperatures above the sintering temperatures of the inorganic binder, and (2) that they do not undergo sintering during the firing step of the invention. Thus, in the context of this invention, the term "ceramic solids: refers to inorganic materials, usually oxides, which undergo essentially no sintering and have a limited tendency to dissolve in the inorganic binder under the conditions of firing to which they are subjected in the practice of the invention.

Subject to the above criteria, virtually any high melting inorganic solid can be used as the ceramic solids component of dielectric tape to modulate the electrical dielectric performance (e.g., K, DF, TCC) as well as the physical characteristics of the dielectric after firing. Examples of possible ceramic filler additives include Al₂O₃, ZrO₂, TiO₂, BaTiO₃, CaTiO₃, SrTiO₃, CaZrO₃, SrZrO₃, BaZrO₃, CaSnO₃, BaSnO₃, PbTiO3, metal carbides such as silicon carbide, metal nitrides such as aluminum nitride, minerals such as mullite and kyanite, cordierite, zirconia, forsterite, anorthite, and various forms of silica or mixtures thereof.

Ceramic solids may be added to the dielectric composition in an amount of 0-50 wt. % based on solids. Depending on the type of filler, different crystalline phases are expected to form after firing. The filler can control dielectric constant and thermal expansion properties. For example, the addition of BaTiO₃ can increase the dielectric constant significantly.

Al₂O₃ is the preferred ceramic filler since it reacts with the glass to form an AI-containing crystalline phase. Al₂O₃ is very effective in providing high mechanical strength and inertness against detrimental chemical reactions. Another function of the ceramic filler is rheological control of the entire system during firing. The ceramic particles limit flow of the glass by acting as a physical barrier. They also inhibit sintering of the glass and thus facilitate better burnout of the organics. Other fillers, α-quartz, CaZrO₃, mullite, cordierite, forsterite, zircon, zirconia, BaTiO₃, CaTiO₃, MgTiO₃, SiO₂, amorphous silica or mixtures thereof may be used to modify tape performance and characteristics.

In the formulation of tape compositions, the amount of glass frit (glass composition) relative to the amount of ceramic (filler) material is important. A filler range of 10-40% by weight is considered desirable in that the sufficient densification is achieved. If the filler concentration exceeds 50% by wt., the fired structure is not sufficiently densified and is too porous. Within the desirable glass/filler ratio, it will be apparent that, during firing, the liquid glass phase will become saturated with filler material.

For the purpose of obtaining higher densification of the composition upon firing, it is important that the inorganic solids have small particle sizes. In particular, substantially all of the particles should not exceed 15 µm and preferably not exceed 10 µm. Subject to these maximum size limitations, it is preferred that at least 50% of the particles, both glass and ceramic filler, be greater than 1.0 µm and less than 6 µm.

The specific type of glass chemistry is not critical to the embodiment of this invention, and can contain a wide range of possible constituents, depending on the specific application where the photosensitive tape is to be used. Several glass compositions are detailed in Table 1 below. For example, in situations where a lead based glass would be acceptable, a glass such as Glass A might be incorporated. For applications where lead-containing glass is not acceptable, but where high reliability dielectric properties are still needed after firing the tape composition at 850 degrees C, a glass of the type "B" might be incorporated. Still further to the broad potential applications where the embodiment might be applied, Glass C describes a chemistry that could be used in applications where low firing temperatures are needed because of the type of substrate to be used, i.e., such as soda lime glass substrates.

**Table 1: Examples of Several Embodiments of Glass Compositions and Solids Compositions of the Present Invention**

| Ingredients | Solids A | Solids B | Solids C |
|---|---|---|---|
| Glass A | 27.6 | 0 | 0 |
| Glass B | 0 | 42.2 | 0 |
| Glass C | 0 | 0 | 49 |
| Alumina | 21.7 | 18.9 | 16.3 |
| Cobalt Aluminate | 0.3 | 0.2 | 0 |
| | | | |

| Ingredients | Glass A | Glass B | Glass C |
|---|---|---|---|
| PbO | 17.2 | 0 | 0 |
| SiO₂ | 56.5 | 38.64 | 7.11 |
| B₂O₃ | 4.5 | 0 | 8.38 |
| Na₂O | 2.4 | 0 | 0 |
| K₂O | 1.7 | 0 | 0 |
| MgO | 0.6 | 0 | 0 |
| CaO | 8 | 14.76 | 0.53 |
| Al₂O₃ | 9.1 | 0 | 2.13 |
| BaO | 0 | 12.66 | 0 |
| ZrO₂ | 0.0 | 2.5 | 0.0 |
| ZnO | 0 | 29.97 | 12.03 |
| P₅O₂ | 0 | 1.45 | 0 |
| Bi₂O₃ | 0 | 0 | 69.82 |

Tables 2 and 3 detail the typical Particle Size Distribution (PSD) in microns for the Glass Powders "A" and "B" in Table 1.

**Table 2: Glass A PSD, microns (typical)**

| D(10) | D(50) | D(90) | D(100) |
|---|---|---|---|
| 0.774 | 2.118 | 4.034 | 9.25 |
| 0.832 | 2.598 | 5.035 | 11.00 |

**Table 3: Glass B PSD, microns (typical)**

| | |
|---|---|
| D(10) | 0.95-1.05 microns |
| D(50) | 2.4 - 3.0 microns |
| D(90) | 5.0 - 6.5 microns |

### ORGANIC CONSTITUENTS

### Polymeric Binder

The organic constituents in which the amorphous glass powder and optional ceramic inorganic solid powders are dispersed is comprised of one or more acrylic-based polymeric binders, one or more photosensitive acrylic-based monomers which will cross link and provide differentiation after exposure to UV actinic light, one or more initiator which facilitates the photo process and one or more plasticizers, all of which are dissolved in a volatile organic solvent. The "slurry" or combination of all the organic ingredients and the inorganic powders comprised of the amorphous glass powder and the optional inorganic "filler" additives is commonly referred to as the "slip" by those familiar in the art and, optionally, other dissolved materials such as release agents, dispersing agents, stripping agents, antifoaming agents, stabilizing agents and wetting agents.

Once the wet "slip" has been coated on to a suitable backing material at the desired thickness and has been dried to get rid of all low boiling solvent, the photosensitive "tape" results.

The polymer binder(s) are critical to the composition of the present invention. Additionally, the polymer binders of the present invention render the tape to be developable in an aqueous base solution of 0.4%-2.0 weight % base (Na₂CO₃ or K₂CO₃) allowing high resolution of features exposed to the UV actinic radiation, and furthermore, giving good green strength, flexibility and lamination properties of the cast tape. The polymer binders are made of copolymer, interpolymer or mixtures thereof, wherein each copolymer or interpolymer comprises (1) a nonacidic comonomer comprising a C₁₋₁₀ alkyl acrylate, C₁₋₁₀ alkyl methacrylate, styrenes, substituted styrenes, or combinations thereof and (2) an acidic comonomer comprising ethylenically unsaturated carboxylic acid containing moiety, the copolymer, interpolymer mixture having an acid content of at least 15% by weight. The mixture may comprise copolymers, interpolymers or both. The acidic polymer binder must be developed by a solution containing a basic component.

The presence of acidic comonomer components in the composition is important in this technique. The acidic functional group provides the ability to be developed in aqueous bases such as aqueous solutions of 0.4-2.0 weight% sodium carbonate or potassium carbonate. When acidic comonomers are present in concentrations of less than 10%, the composition is not washed off completely with an aqueous base. When the acidic comonomers are present at concentrations greater than 30%, the composition is less resistant under development conditions and partial development occurs in the imaged portions. Appropriate acidic comonomers include ethylenically unsaturated monocarboxylic acids such as acrylic acid, methacrylic acid, or crotonic acid and ethylenically unsaturated dicarboxylic acids such as fumaric acid, itaconic acid, citraconic acid, vinyl succinic acid, and maleic acid, as well as their hemiesters, and in some cases their anhydrides and their mixtures.

It is preferred that the nonacidic comonomers constitute at least 50 wt% of the binder polymer. Although not preferable, the nonacidic portion of the polymer binder can contain up to about 50 wt. % of other nonacidic comonomers as substitutes for the alkyl acrylate, alkyl methacrylate, styrene, or substituted styrene portions of the polymer. Examples include acrylonitrile, vinyl acetate, and acrylamide. However, because it is more difficult for these to completely burn out, it is preferable that less than about 25 wt. % of such monomers in the total polymer binder are used.

The use of single copolymers or combinations of copolymers as binders are recognized as long as each of these satisfies the various standards above. In addition to the above copolymers, adding small amounts of other polymer binders is possible. For examples of these, polyolefins such as polyethylene, polypropylene, polybutylene, polyisobutylene, and ethylene-propylene copolymers, polyvinyl alcohol polymers (PVA), polyvinyl pyrrolidone polymers(PVP), vinyl alcohol and vinyl pyrrolidone copolymers, as well as polyethers that are low alkylene oxide polymers such as polyethylene oxide can be cited.

The polymers described herein can be produced by those skilled in the art of acrylate polymerization by commonly used solution polymerization techniques. Typically, such acidic acrylate polymers are produced by mixing α- or β-ethylenically unsaturated acids (acidic comonomers) with one or more copolymerizable vinyl monomer (nonacidic comonomers) in a relatively low-boiling-point (75-150°C) organic solvent to obtain a 10-60% monomer mixture solution, then polymerizing the monomers by adding a polymerization catalyst and heating the mixture under normal pressure to the reflux temperature of the solvent. After the polymerization reaction is essentially complete, the acidic polymer solution produced is cooled to room temperature.

A reactive molecule, a free radical polymerization inhibitor and a catalyst are added to the cooled polymer solution described above. The solution is stirred until the reaction is complete. Optionally, the solution may be heated to speed up the reaction. After the reaction is complete and the reactive molecules are chemically attached to the polymer backbone, the polymer solution is cooled to room temperature, samples are collected, and the polymer viscosity, molecular weight, and acid equivalents are measured.

### Plasticizer

Plasticizer is essential to the dielectric thick film tape utilized in the PTOS applications of the present invention. The use of the plasticizer in the tape is optimized to satisfy several properties of the tape both before, during and after the hot roll lamination process has occurred to allow for hot roll lamination by providing a flexible conformal tape composition. If too much plasticizer is used, the tape will stick together. If too little plasticizer is used, the tape may chip during processing. The plasticizer, in combination with the polymer binder of the composition, contributes to the desired adhesive properties of the tape, thus allowing the tape film to adhere to the substrate upon hot roll lamination.

Additionally, the plasticizer serves to lower the glass transition temperature (Tg) of the binder polymer. The ratio of plasticizer to polymer binder is in the range of 4:23 to 7:9. The plasticizer is present in the total composition in 1-12 wt. %, more preferably 2-10%, and most preferably, 4 - 8% by weight of the total dried tape composition.

The choice of plasticizers, of course, is determined primarily by the polymer that needs to be modified. Among the plasticizers which have been used in various binder systems are diethyl phthalate, dibutyl phthalate, dioctyl phthalate, butyl benzyl phthalate, alkyl phosphates, polyalkylene glycols, glycerol, poly(ethylene oxides), hydroxyethylated alkyl phenol, dialkyldithiophosphonate and poly(isobutylene). Of these, butyl benzyl phthalate is most frequently used in acrylic polymer systems because it can be used effectively in relatively small concentrations. Preferred plasticizers are BENZOFLEX® 400 as well as BENZOFLEX® P200 manufactured by the Velsicol Company, which are a polypropylene glycol dibenzoate, and polyethylene glycol dibenzoate, respectively.

### Photoinitiation System (Photoinitiator)

Suitable photoinitiation systems are those which are thermally inactive, but which generate free radicals upon exposure to actinic radiation at or below 185°C. "Actinic radiation" means light rays, violet and ultraviolet light, X-rays, or other radiations by which chemical changes are produced. Certain photo initiators, even though thermally inactive, can generate free radicals at a temperature of 185°C or lower under exposure to actinic radiation. Examples include substituted or non-substituted polynuclear quinones, compounds having two inner molecular rings in a conjugated carbon ring system, such as 9,10-anthraquinone, 2-methylanthraquinone, 2-ethylanthraquinone, 2-tert-butylanthraquinone, octamethylanthraquinone, 1,4-naphthoquinone, 9,10-phenanthraquinone, benz(a)anthracene-7,12-dione, 2,3-naphthacene-5,12-dione, 2-methyl-1,4-naphthoquinone, 1,4-dimethylanthraquinone, 2,3-dimethylanthraquinone, 2-phenylanthraquinone, 2,3-diphenylanthraquinone, retene quinone, 7,8,9,10-tetrahydronaphthacene-5,12-dione, and 1,2,3,4-tetrahydrobenz(a)anthracene-7,12-dione. U.S. Patent No. 2,760,863 disclosed some other useful optical initiators that are thermally active even at a temperature as low as 85°C. They are vicinal (vicinal) ketal donyl alcohols such as benzoin, and pivaloin, acyloin ethers such as benzoin methyl and ethyl ether, as well as α-hydrocarbon-substituted aromatic acyloins such as α-methylbenzoin, α-allylbenzoin, and α-phenylbenzoin.

The photoreductive dyes and reducing agents disclosed in U.S. Patent Nos. 2,850,445, 2,875,047, 3,097,096, 3,074,974, 3,097,097, 3,145,104, 3,427,161, 3,479,186, and 3,549,367, such as phenatine, oxatine, and Michler's ketone (Michler's ketone) of the quinone class, benzophenone, and 2,4,5-triphenylimidazole dimer having hydrogen suppliers can be used as the initiators. Also, the sensitizer disclosed in U.S. Patent No. 4,162,162 can be used together with the optical initiator and photopolymerization inhibitor. The content of the optical initiator varies. In one embodiment, the content of the optical initiator is in the range of 0.02 -12 weight % with respect to the total weight of the dried photopolymerizable tape film layer. In a further embodiment, the optical initiator is present in the range of 0.1-3 weight %, and in still a further embodiment the optical initiator is present in the range of 0.2-2 weight %. One particularly useful photo initiator for the practice of this embodiment is Irgacure® 369 manufactured by Ciba Specialty Chemicals.

### Photohardenable Monomer

The photocurable monomer component used in the dielectric tape is formed with at least one addition polymerizable ethylene type of unsaturated compound having at least one polymerizable ethylene group.

This compound is made from free radicals, then grown into chains, which are subjected to addition polymerization to form a polymer. The monomer compound is non-gaseous. In other words, it has a boiling point of 100°C or higher and can be plasticized on an organic polymerizable binder.

Examples of appropriate monomers that can be used either alone or in combination with other monomers include t-butyl acrylate and methacrylate, 1,5-pentanediol diacrylate and dimethacrylate, N,N-dimethylaminoethyl acrylate and methacrylate, ethylene glycol diacrylate and dimethacrylate, 1,4-butanediol acrylate and methacrylate, diethylene glycol, diacrylate and dimethacrylate, hexamethylene glycol diacrylate and methacrylate, 1,3-propanediol diacrylate and dimethacrylate, decamethylene glycol diacrylate and methacrylate, 1,4-cyclohexanediol diacrylate and dimethacrylate, 2,2-dimethylolpropane diacrylate and dimethacrylate, glycerol diacrylate and dimethacrylate, tripropylene glycol diacrylate and dimethacrylate, glycerol triacrylate and trimethacrylate, trimethylolpropane triacrylate and trimethacrylate, pentaerythritol triacrylate, and methaacrylate, polyoxyethylated trimethylolpropane triacrylate and trimethacrylate, and the same compounds disclosed in U.S. Patent No. 3,380,381, 2,2-di(p-hydroxyphenyl)-propane diacrylate, pentaerythritol tetraacrylate and tetramethacrylate, 2,2-di-(p-hydroxyphenyl)-propanediacrylate, pentaerythritol tetraacrylate and tetramethacrylate, 2,2-di(p-hydroxyphenyl)-propanedimethaacrylate, triethylene glycol diacrylate, polyoxyethyl-1,2-di-(p-hydroxyphenyl)propane dimethacrylate, di-(3-methacryloxy-2-hydroxypropyl)ether of bisphenol-A, di-(3-acryloxy-2-hydroxypropyl)ether of bisphenol A, di(2-methaklyoxyethyl)ether of bisphenol-A, di(2-acryloxyethyl)ether of bisphenol-A, di-(3-methalkyloxy-2-hydroxypropyl)ether of 1,4-butanediol, triethylene glycol dimethacrylate, polyoxypropyl trimethylol propanetriacrylate, butylene glycol diacrylate and dimethacrylate, 1,2,4-butanetriol triacrylate and trimethacrylate, 2,2,4-trimethyl-1,3-pentanediol diacrylate and dimethacrylate, 1-phenylethylene-1,2-dimethacrylate, diallyl fumarate, styrene, 1,4-benzenediol dimethacrylate, 1,4-diisopropenylbenzene, and 1,3,5-triisopropenylbenzene.

It is also possible to use ethylene-type unsaturated compounds having a molecular weight of at least 300, such as the alkylene or polyalkylene glycol diacrylate manufactured from a C2-15 alkylene glycol or polyalklyene glycol having 1-10 ether bonds as well as the compounds disclosed in U.S. Patent No. 2,927,022, especially those compounds having multiple addition polymerizable ethylene bonds when they are present as the terminal bonds.

Preferable examples of the monomers include polyoxyethylated trimethylolpropane triacrylate and trimethacrylate, ethylated pentaerythritol triacrylate, trimethylol propane triacrylate and trimethacrylate, dipentaerythritol monohydroxy pentaacrylate, and 1,10-decanediol dimethyl acrylate.

Other preferable monomers include monohydroxypolycaprolactone monoacrylate, polyethylene glycol diacrylate (molecular weight: about 200), and polyethylene glycol 400 dimethacrylate (molecular weight: about 400). The content of the unsaturated monomer component is preferably in the range of 2-20 wt% of the total weight of the dried photopolymerizable tape film layer, more preferably 2-12% and most preferably, 2-7% of the dry tape film layer. One particularly useful monomer for the practice of this embodiment is CD582, also known as alkoxylated cyclohexane diacrylate, manufactured by Sartomer Company.

### Organic Solvent

The solvent component of the casting solution is chosen so as to obtain complete dissolution of the polymer and sufficiently high volatility to enable the solvent to be evaporated from the dispersion by the application of relatively low levels of heat at atmospheric pressure. In addition, the solvent must boil well below the boiling point or the decomposition temperature of any other additives contained in the organic medium. Thus, solvents having atmospheric boiling points below 150°C are used most frequently. Such solvents include acetone, xylene, methanol, ethanol, isopropanol, methyl ethyl ketone, ethyl acetate, 1,1,1-trichloroethane, tetrachloroethylene, amyl acetate, 2,2,4-triethyl pentanediol-1,3-monoisobutyrate, toluene, methylene chloride and fluorocarbons. Individual solvents mentioned above may not completely dissolve the binder polymers. Yet, when blended with other solvent(s), they function satisfactorily. This is well within the skill of those in the art. A particularly preferred solvent is ethyl acetate since it avoids the use of environmentally hazardous chlorocarbons.

Additional components known in the art may be present in the composition including dispersants, stabilizers, release agents, dispersing agents, stripping agents, antifoaming agents and wetting agents. A general disclosure of suitable materials is presented in U.S. Patent No. 5,049,480, which is incorporated herein.

### Applications

### Tape Preparation

The composition(s) of the present invention are used to form a film as a wet slurry or "slip" on a suitable backing materials. The material which is often used for the backing is "mylar". Other possible backing materials might be polypropylene, nylon, and although not narrowly critical to the application of the present invention, should have suitable properties to allow the satisfactory practice of the present invention. For example, the tape on the backing material after drying (the film when dried to remove the solvent is called "the tape") should have sufficient adhesion to the backing to stick together and not "delaminate" through the hot roll lamination step, but should easily come apart once the hot roll lamination step has been completed.

A conformable entity is defined as any structure comprising the composition of the present invention that allows for hot roll lamination. We will discuss the conformable entity in general terms of tape formation. To form the tape, a slip is prepared and used for tape casting. Slip is a general term used for the composition in tape making and is a properly dispersed mixture of inorganic powders dispersed in an organic medium.

Although it is not narrowly critical to the practice of the present invention, a common way of achieving a good dispersion of inorganic powders in the organic medium is by using a conventional ball-milling process. A ball milling consists of ceramic milling jar and milling media (spherical or cylindrical shaped alumina or zirconia pellets). The total mixture is put into the milling jar containing the milling media. After closing the jar with a leak-tight lid, it is tumbled to create a milling action of the milling media inside the jar at a rolling speed at which the mixing efficiency is optimized. The length of the rolling is the time required to attain well-dispersed inorganic particles to meet the performance specifications. Generally, a milling or mixing time of 1-20 hours is sufficient to result in the desired level of dispersion. The slip may be applied to a backing by a blade or bar coating method, followed by ambient or heat drying. The coating thickness after drying may range from a few microns to several tens of microns depending on the end application in which the tape will be used.

The conformable photosensitive dielectric "green" (i.e., "unfired") tape(s) for use in the present invention are formed by casting a layer of desired thickness of a sluny dispersion of inorganic binder, optional ceramic solids, polymeric binder, plasticizer, photoinitiator, photohardenable monomer, and solvent as described above onto a flexible backing and air drying or heating the cast layer to remove the volatile solvent. The backing may be made from a multitude of flexible materials, but is typically Mylar. The tape (coating + e.g., Mylar backing) may then be formed into sheets or collected in a roll form, and sized according to the dictates of the final application for which the tape is intended to be used. (NOTE: Once the tape has been applied to the rigid substrate by hot roll lamination, the backing is generally removed and discarded.)

In the method(s) of present invention, the backing material will usually remain together with the photosensitive ceramic-containing tape through the hot roll lamination stage and removed prior to exposure of the photosensitive tape. In the case where the backing material is a clear transparent Mylar, or other suitable material which allows exposure to UV actinic light, the backing material could remain on the tape surface even through exposure to the actinic UV light, for example to provide protection of the surface from unwanted contaminations. In this case, the transparent backing material would be removed just before the development step.

It is preferred that the dried tape not exceed a thickness of 65-75 mils (1651-1905 µm). Thicker tapes will often create problems during the firing step when using conventional belt furnaces with total firing cycle times of 30-60 minutes (defined as total time above 100°C). In cases where thicker films are required by the application, it would be possible to circumvent the firing sensitivity by using an elongated firing profile not practically feasible for many hybrid circuit manufacturers.

Additionally, a cover sheet may be applied to the tape before it is wound as a "widestock" (master) roll. Examples of typical coversheets include, mylar, silicone coated mylar (terephthalate PET), polypropylene, and polyethylene, or nylon. Typically, the coversheet is removed just before hot roll lamination to the final rigid substrate.

### Suitable Dimensionally Stable Substrates

A "dimensionally stable substrate" as described in the present invention is any solid material, including solid materials comprising ceramic, glass, and metal, which does not noticeably change shape or size under the firing conditions required to sinter and bond the film materials of the present invention to the substrate. Suitable dimensionally stable substrates might include, but are not limited to, conventional ceramics such as alumina, α-quartz, CaZrO₃, mullite, cordierite, forsterite, zircon, zirconia, BaTiO₃, CaTiO₃, MgTiO₃, SiO₂, glass-ceramics, and glasses (amorphous structures, e.g., comprised of soda lime glass or higher melting amorphous structures), amorphous silica or mixtures thereof. Other suitable dimensionally stable substrate materials might be stainless steel, iron and its various alloys, porcelainized steel, other base metals such as nickel, molybdenum, tungsten, copper, as well as platinum, silver, palladium, gold and their alloys, or other precious noble metals and their alloys, and other metal substrates determined to be suitable based on their final application. In particular, one iron alloy that is a suitable substrate is Kovar® (Ni-Fe alloy) substrate. The tape can also be laminated to other electrical substrate assemblies already formed (fired), in order to customize the electrical circuit functionality further. Such substrates might be ceramic hybrid microelectronic circuits already fired on alumina, or circuits comprised of 951 "Green Tape™", 943 "Green Tape™" (both by E.I. du Pont de Nemours and Company), or other LTCC circuits which are now commercially available.

### Multilayer Circuit Formation

The multilayer electric circuit is formed by supplying a dimensionally stable substrate, which can be any substrate compatible with the thermal coefficient of expansion (TCE) of the conformable photosensitive dielectric tape after it has been fired on to the substrate material. Examples of dimensionally stable substrates include, but are not limited to, alumina, glass, ceramic, α-quartz, CaZrO₃ mullite, cordierite, forsterite, zircon, zirconia, BaTiO₃, CaTiO₃, MgTiO₃, SiO₂, amorphous silica or mixtures thereof. Other suitable substrate materials might be stainless steel, iron and its various alloys, porcelainized steel, other base metals such as nickel, molybdenum, tungsten, copper, as well as platinum, silver, palladium, gold and their alloys, or other precious noble metals and their alloys, and other metal substrates determined to be suitable based on their final application. The tape can also be laminated to other electrical substrate assemblies already formed (fired), in order to customize the electrical circuit functionality further. Such substrates might be ceramic hybrid microelectronic circuits already fired on alumina, or circuits comprised of 951 "Green Tape™", 943 "Green Tape™" (available from E.I. du Pont de Nemours and Company), or other LTCC circuits which are now commercially available.

The dimensionally stable substrate is then optionally coated with a functional or conductive layer, applied in the desired pattern by conventional screen printing or by commercially available photo definition techniques (e.g., Fodel® silver paste, product number 6453 from the E.I. du Pont de Nemours and Company). The conductive paste is typically dried at a suitable temperature to remove all solvent before proceeding. For the first metallization layer on the rigid substrate, the functional conductive film must be fired before applying the photosensitive dielectric tape layer.

Next, the photosensitive dielectric "green" tape is hot-roll laminated to the dimensionally stable substrate. The photosensitive tape is then exposed in the desired pattern thus creating crosslinked or polymerized areas where actinic radiation was applied and uncrosslinked or unpolymerized areas, where the light was not applied. The uncrosslinked (unpolymerized) areas are then washed off using a dilute solution of 0.4-2.0% by weight of sodium or potassium carbonate, thus forming the desired pattern of vias or other desired structures (e.g., cavities, steps, walls). The e.g., vias may then be filled with a conductive metallization (i.e. the via fill composition of the present invention). Next, patterned functional conductive layer(s) (additional metallization layers) may be coated on the via filled tape layer to form a circuit assembly. After the first dielectric assembled layer has been fired, the process steps may be repeated as needed or desired, i.e., from the photosensitive tape hot-roll lamination to the functional layer coating, firing each assembled dielectric tape layer before proceeding to the next layer.

The interconnections between layers are formed by filling the via holes with a thick film conductive ink. This ink is usually applied by standard screen printing techniques. Each layer of circuitry is completed by screen printing conductor tracks. Also, resistor inks or high dielectric constant inks can be printed on selected layer(s) to form resistive or capacitive circuit elements.

As used herein, the term "firing" means heating the assembly in an oxidizing atmosphere such as air to a temperature, and for a time sufficient to volatilize (burn-out) all of the organic material in the layers of the assemblage to sinter any glass, metal or dielectric material in the layers and thus densify the entire assembly. Firing is typically performed in a belt furnace, such as manufactured by Sierra Therm, BTU, and Lindberg, among others.

The term "functional layer" refers to the conductive composition applied by screen printing, stenciling ink jetting or other methods to the tape, which has already been hot roll laminated to the dimensionally stable substrate. The functional layer can have conductive, resistive or capacitive functionality. Thus, as indicated above, each typical unfired tape layer may have printed thereon one or more combinations of resistor, capacitor, and/or conductive circuit elements, which will become functional once the assembly has been fired.

### EXAMPLES

Examples 1-13 are provided to demonstrate the PTOS technology in general and were first presented in U.S. Patent Application 10/910126 to Bidwell et al. Examples 14 and 15 demonstrate the effectiveness of the via fill composition of the present invention, as utilized in PTOS technology.

For Examples 1-10 and Example 12, the tape thickness of the dried photosensitive film was typically 65-85 microns. Tables 4-7 and Table 9 detail the compositions used in each Example. Table 8 and 10 detail the results of the Examples.

**Table 4: Glass Compositions in Weight Percent Total Glass Composition**

| Ingredients | Glass A | Glass B | Glass C |
|---|---|---|---|
| PbO | 17.2 | 0 | 0 |
| SiO₂ | 56.5 | 38.64 | 7.11 |
| B₂O₃ | 4.5 | 0 | 8.38 |
| Na₂O | 2.4 | 0 | 0 |
| K₂O | 1.7 | 0 | 0 |
| MgO | 0.6 | 0 | 0 |
| CaO | 8 | 14.76 | 0.53 |
| A₁₂O₃ | 9.1 | 0 | 2.13 |
| BaO | 0 | 12.66 | 0 |
| ZrO₂ | 0.0 | 2.5 | 0.0 |
| ZnO | 0 | 29.97 | 12.03 |
| P₂O₅ | 0 | 1.45 | 0 |
| Bi₂O₃ | 0 | 0 | 69.82 |

**Table 5: Solids Composition in Weight Percent Total Composition**

| Ingredients | Solids A | Solids B | Solids C |
|---|---|---|---|
| Glass A | 27.6 | 0 | 0 |
| Glass B | 0 | 42.2 | 0 |
| Glass C | 0 | 0 | 49 |
| Alumina | 21.7 | 18.9 | 16.3 |
| Cobalt Aluminate | 0.3 | 0.2 | 0 |

**Table 6: Polymer Composition (Weight Percent of Total Polymer Composition) and Characteristics**

| | **Polymer** | | | | | |
|---|---|---|---|---|---|---|
| **Patent Examples Cross Reference** | **A** | **B** | **C** | **D** | **E** | **F** |
| **Methyl Methacrylate** | 21 | 38 | 35 | 80 | 75 | 70 |
| **Methylacrylic Acid** | 21 | 24 | 21 | 20 | 25 | 20 |
| **Ethyl Acrylate** | 38 | 38 | 19 | X | X | X |
| **Butyl Acetate** | X | X | X | X | X | 10 |
| **Styrene** | 20 | X | X | X | X | X |
| **n-Butyl Methyl Acrylate** | X | X | 25 | X | X | X |
| **Acid Number** | 135 | 145 | 130 | 118 | na | na |
| **Glass Transition Point, T_{g}** | 80 | 91 | 92 | 105 | na | na |
| **Molecular Weight (x10³)** | 68 | 57 | 80 | 7 | 28 | 21 |

**Table 7: Composition of Examples (Weight Percent Total Composition)**

| Example Number | 1 | 2 | 3 | 4 | 5 | 6 |
|---|---|---|---|---|---|---|
| Solids A | 49.6 | 0 | 0 | 0 | 0 | 0 |
| Solids B | 0 | 61.3 | 61.3 | 61.3 | 61.3 | 61.3 |
| Solids C | 0 | 0 | 0 | 0 | 0 | 0 |
| Polymer A | 10.12 | 3 | 0 | 0 | 0 | 0 |
| Polymer B | 0 | 0 | 0 | 3 | 0 | 10 |
| Polymer C | 0 | 0 | 0 | 0 | 3 | 0 |
| Polymer D | 0 | 9.1 | 10 | 9.1 | 9.1 | 0 |
| Polymer E | 0 | 0 | 0 | 0 | 0 | 0 |
| Polymer F | 0 | 0 | 0 | 0 | 0 | 0 |
| SR508 | 5.8 | 0 | 0 | 0 | 0 | 0 |
| CD582 | 0 | 4.6 | 3 | 4.6 | 4.6 | 3 |
| Irgacure® 369 | 0.02 | 0.27 | 0.25 | 0.27 | 0.27 | 0.25 |
| Benzoflex® 400 | 1.92 | 2.3 | 6.2 | 2.3 | 2.3 | 6.2 |
| Benzoflex® 200 | 0 | 0 | 0 | 0 | 0 | 0 |
| Malonic Acid | 0 | 0.14 | 0.14 | 0.14 | 0.14 | 0.14 |
| Ethyl Acetate | 32.54 | 19.3 | 19.1 | 19.3 | 19.3 | 19.1 |
| Acetone | 0 | 0 | 0 | 0 | 0 | 0 |
| total | 100.0 | 100.0 | 100.0 | 100.0 | 100.0 | 100.0 |

**Table 8: Characteristics of Examples 1-6**

| Tape Characteristics | Example 1 | Example 2 | Example 3 | Example 4 | Example 5 | Example 6 |
|---|---|---|---|---|---|---|
| 1) curling | 1 | 1 | 1 | 1 | 1 | 1 |
| 2) delam/mylar | 1 | 1 | 1 | 1 | 1 | 1 |
| 3) brittleness | 1 | 2 | 4 | 5 | 5 | 1 |
| 4)self-lam | 5 | 3 | 4 | 3 | 3 | 3 |
| 5) exposure | 1 | 1 | 1 | 1 | 1 | 2 |
| 6) development | 1 | 3 | 1 | 3 | 5 | 1 |
| 7) hot roll lam | 1 | 1 | 1 | 1 | 1 | 1 |
| 8) PEB | 1 | 1 | 1 | 1 | 1 | 5 |
| 9) fire/60 min | 5 | 1 | 1 | 2 | 5 | 1 |
| 10) fire/30 min | 5 | 2 | 1 | 5 | 5 | 3 |
| sum of results | 22 | 16 | 16 | 23 | 28 | 19 |

| | | | | | | |
|---|---|---|---|---|---|---|
| 1) curling after drying on Mylar 2) delamination from Mylar 3) brittleness (chipping-on-cutting) 4) self-lamination (tacky) 5) loss of photo properties 6) slow development 7) hot roll lamination 8) Need For Post Exposure Back 9) Fired Film With 60 minute profile 10) Fired Film With 30 minute Profile Rating of "1" is "GOOD" Rating of "5" is "BAD" SUM of results: Low Is "GOOD"; e.g. < 20 | | | | | | |

**Table 9: Composition of Examples 7-11 (Weight Percent Total Composition)**

| Example Number | 7 | 8 | 9 | 10 | 11 |
|---|---|---|---|---|---|
| Solids A | 0 | 0 | 0 | 0 | 0 |
| Solids B | 61.3 | 61.3 | 61.3 | 61.3 | 0 |
| Solids C | 0 | 0 | 0 | 0 | 65.3 |
| Polymer A | 0 | 0 | 0 | 0 | 0 |
| Polymer B | 0 | 0 | 0 | 0 | 0 |
| Polymer C | 0 | 0 | 0 | 0 | 0 |
| Polymer D | 9.17 | 0 | 0 | 0 | 7.98 |
| Polymer E | 0 | 0 | 10 | 10 | 0 |
| Polymer F | 0 | 10 | 0 | 0 | 0 |
| SR508 | 0 | 0 | 0 | 0 | 0 |
| CD582 | 3 | 3 | 3 | 3 | 4.6 |
| Irgacure® 369 | 0.25 | 0.25 | 0.25 | 0.25 | 0.18 |
| Benzoflex® 400 | 7.03 | 6.2 | 6.2 | 0 | 1.54 |
| Benzoflex® 200 | 0 | 0 | 0 | 6.2 | 0 |
| Malonic Acid | 0.14 | 0.14 | 0.14 | 0.14 | 0.16 |
| Ethyl Acetate | 19.1 | 0 | 0 | 0 | 20.2 |
| Acetone | 0 | 19.1 | 19.1 | 19.1 | 0 |
| total | 100.0 | 100.0 | 100.0 | 100.0 | 100.0 |

**Table 10: Characteristics of Examples 7-11**

| Tape Characteristics | Example 7 | Example 8 | Example 9 | Example 10 | Example 11 |
|---|---|---|---|---|---|
| 1) curling | 1 | 1 | 5 | 1 | 1 |
| 2) delam/mylar | 1 | 1 | 5 | 1 | 1 |
| 3) brittleness | 1 | 3 | 5 | 2 | 4 |
| 4)self-lam | 5 | 3 | 1 | 2 | 4 |
| 5) exposure | 1 | 1 | 5 | 1 | 1 |
| 6) development | 1 | 1 | 5 | 1 | 1 |
| 7) hot roll lam | 1 | 1 | 5 | 1 | 1 |
| 8) PEB | 1 | 1 | 5 | 1 | 1 |
| 9) fire/60 min | 1 | 1 | 5 | 1 | 1 |
| 10) fire/30 min | 2 | 2 | 5 | 2 | 1 |
| Sum of results | 15 | 15 | 46 | 13 | 16 |

| | | | | | |
|---|---|---|---|---|---|
| 1) curling after drying on Mylar 2) delamination from Mylar 3) brittleness (chipping-on-cutting) 4) self-lamination (tacky) 5) loss of photo properties 6) slow development 7) hot roll lamination 8) Need For Post Exposure Bake (PEB) 9) Fired Film With 60 minute profile 10) Fired Film With 30 minute Profile Rating of "1" is "GOOD" Rating of "5" is "BAD" SUM of results: Low Is "GOOD"; e.g. < 20 | | | | | |

### Example 1

An adhesive layer of photosensitive tape formed from the composition of Example 1 described above, and as described in Tables 4-7 (and prepared as described above under Tape Preparation) was first hot roll laminated at a lamination temperature of 85-120°C and 0.2-0.4 m/min throughput speed with air assist deactivated (DuPont LC-2400 Hot Roll Lamination machine) to the substrate (3" X 3" 96% alumina substrate commercially available from the COORS Corporation.). This adhesive layer was not exposed, but is used as the "Adhesive" for the second layer. Next, a second layer of the tape composition (65 microns), as described above Example 1, which was covered with a 1 mil (25.4 µm) mylar cover sheet (flexible backing), was hot roll laminated over the first adhesive layer. The second layer of tape was exposed to actinic radiation (OAI Mask Aligner, Model J500, using a 500 watt UV mercury short arc bulb), through a patterned image (glass phototool) for approximately 8-9 seconds (bulb output = 7-10 mwatts/cm² measured with an International Light, Model IL1400A radiometer with a XRL140A photodetector, measuring in the UVA band at 315-400 nm). The exposed substrate was then subjected to a post-exposure bake in air at approximately 150°C for 2 minutes. After the post-exposure bake the mylar cover sheet was removed. The tape was then developed in an aqueous base solution of 1% sodium carbonate at approximately 85°F (29°C) at a development speed of 3.7-4.0 ft/min (1.12-1.22 m/min). This was accomplished using an Advanced Systems Incorporated (ASI) Model 757/857 Developer/Rinse System at 25 p.s.i. (170 kPa) nozzle pressure with a fan spray configuration. The tape characteristics observed are detailed in Table 8. This example shows that it is not possible to achieve suitable performance capability because of excessive self-lamination and extremely poor firing sensitivity, due to the high monomer level and low plasticizer level.
NOTE: The exposure time (energy) required, depends on the feature sizes being exposed and the light absorption characteristics of the phototool being used (e.g., glass type, Mylar grade, etc).

### Example 2

A layer of the tape formed from the composition of Example 2 (Table 4-7) was hot roll laminated (as described in Example 1), with air assist activated, to the substrate. Note: Air assist was "activated" for all the remaining examples. (The substrate was 96% alumina as in Example 1). The photosensitive tape in this case did not contain a cover sheet, but was on a mylar backing, as in Example 1. The photosensitive tape was then exposed to actinic radiation through a patterned image on mylar for approximately 4-10 seconds. (In this case and for all other examples, the exposure unit was an ORIEL Model 82430 using a 1000 watt mercury-xenon lamp, with an output set at 14.5 mwatts/cm² measured as described above.) The exposed tape on the alumina substrate was then developed in an aqueous base solution of 1% sodium carbonate at approximately 85°F (29°C) at a development speed of 1.0 ft/min (0.3 m/min). The tape characteristics observed are detailed in Table 8. This composition had excellent performance with hot roll lamination, gave good firing capability but gave poor development speed and poor wash out of photo-defined features.

### Example 3 (Tables 4- 8)

A layer of the tape formed from the composition of Example 3 was hot roll laminated to the substrate (96% alumina as described above in Examples 1 and 2. This type of alumina substrate was also used for Examples 4-10). The photosensitive tape contained no cover sheet. No cover sheet was used for the remaining examples. The tape was then exposed to actinic radiation through a patterned image on mylar for approximately 3-5 seconds. The exposed substrate/tape was then developed in an aqueous base solution of 1% sodium carbonate at approximately 85°F (29°C) at a development speed of 2-3 ft/min (0.6-0.9 m/min). The tape characteristics observed are detailed in Table 8. Although this example shows one of the best balances in overall performance, the self-lamination tendency might be improved. One way that self-lamination could be removed as an issue is by the use of an organic cover sheet. Although this is technically feasible, from a practical standpoint, it is less advantageous because it adds cost to the overall manufacturing.

### Example 4 (Tables 4- 8)

A layer of the tape formed from the composition of Example 4 was hot roll laminated to the 96% alumina substrate. The tape was then exposed to actinic radiation through a patterned image on mylar for approximately 4-5 seconds. The exposed tape on substrate was then developed in an aqueous base solution of 1% sodium carbonate at approximately 85°F (29°C) at a development speed of approximately 2 ft/min (0.6 m/min). The tape characteristics observed are detailed in Table 8. This composition had extreme brittleness due to an insufficient plasticizer level (2.3%).

### Example 5 (Tables 4- 8)

A layer of the tape formed from the composition of Example 5 was hot roll laminated to the alumina substrate. The tape was then exposed for 3-5 seconds to actinic radiation through a patterned image on mylar. The exposed tape on alumina substrate was then developed in an aqueous base solution of 1 % sodium carbonate at approximately 85°F (29°C) at 1.8 ft/min (0.55 m/min). The tape characteristics observed are detailed in Table 8. Even though Examples 4 and 5 are only different by the chemistry of the longer chain polymer which was added, this example was rated poor for brittleness, development and firing capability, showing that the chemistry of the polymer mix can have a significant effect on the overall performance.

### Example 6 (Tables 4- 8)

A layer of the tape formed from the composition of Example 6 was hot roll laminated to the alumina substrate. The tape was then exposed to actinic radiation through a patterned image on mylar for approximately 3-5 seconds. The exposed substrate/tape was then subjected to a post-exposure bake at approximately 150°C for 2 minutes. Next, the exposed substrate/tape was developed in an aqueous solution of 1% sodium carbonate at approximately 85°F (29°C) at a development speed of 2.3-2.5 ft/min (0.7-0.76 m/min).

For this composition, although the tape film had excellent flexibility due to the long chain polymer content, post exposure bake was required to eliminate surface damage during the development step. Post exposure bake is generally viewed as an added process step, which will adversely affect the customer's throughput and manufacturing cost.

### Example 7 (Tables 4 - 6, 9, 10)

A layer of the tape formed from the composition of Example 7 was hot roll laminated to the alumina substrate. The tape was then exposed to actinic radiation through a patterned image on mylar for approximately 3-5 seconds. The exposed tape on alumina substrate was then developed in an aqueous solution of 1% sodium carbonate at approximately 85°F (29°C) at a development speed of 2-3 ft/min (0.6-0.9 m/min). The tape characteristics observed are detailed in Table 10. This composition had higher plasticizer level than Example 3, and increased the tendency to self-laminate to an unacceptable level. Other performance characteristics were acceptable.

### Example 8 (Tables 4 - 6, 9, 10)

A layer of the tape formed from the composition of Example 7 was hot roll laminated to the alumina substrate. The tape was then exposed to actinic radiation through a patterned image on mylar for approximately 3-5 seconds. The exposed tape on alumina substrate was then developed in an aqueous solution of 1 % sodium carbonate at approximately 85°F (29°C) at a development speed of 2-3 ft/min (0.6-0.9 m/min). The tape characteristics observed are detailed in Table 10. The composition of Example 8 used a different polymer than Example 7, and uses acetone as the solvent. It gave slightly better flexibility and slightly less brittleness. All other performance characteristics were acceptable.

### Example 9 (Tables 4- 6, 9,10)

The composition of Example 9 was extremely brittle after casting on the mylar backing film and dried. It lost adhesion to the mylar backing film and was unable to be processed further. The composition of Example 9 used another polymer described in Tables 4-6 and 9, which had a different chemistry and slightly higher molecular weight than the polymer in Example 8, however, the tape film characteristics overall were much worse than Example 8.

### Example 10 (Tables 4 - 6, 9,10)

A layer of the tape formed from the composition of Example 10 was hot roll laminated to the alumina substrate. The tape was then exposed to actinic radiation through a patterned image on mylar for approximately 1.5-2.5 seconds. The exposed tape on alumina substrate was then developed in an aqueous solution of 1 % sodium carbonate at approximately 85°F (29°C) at a development speed of approximately 3 ft/min (0.9 m/min). The tape characteristics observed are detailed in Table 10. The composition of Example 10 was identical to that of Example 9, but with a different plasticizer used. The overall performance of the tape film in this composition was rated one of the best, showing that choice of plasticizer is important, especially in combination with the choice of polymer.

### Example 11 (Tables 4 - 6, 9,10)

The purpose of Example 11 was to show that the process and formulation of the present disclosure can be successfully applied to other glass chemistries and therefore, could be used for other end use applications. In Example 11, a layer (dried tape thickness = 12 microns) of the tape formed from the composition of Example 11 (see Tables 4-6, 9 and 10) was hot roll laminated to the glass substrate (microscope slide composed of soda lime glass). The tape was then exposed to actinic radiation through a patterned image on mylar for approximately 2-4 seconds. The exposed tape on soda lime glass substrate was then developed in an aqueous solution of 1 % sodium carbonate at approximately 85°F (29°C) with a development speed of 4-6 ft/min (1.22-1.83 m/min). The tape characteristics observed are detailed in Table 10.

The composition of Example 11 shows that this photo imaging technology can be applied broadly to other tape solids and glass chemistries, such as those that might be employed and required in applications such as Plasma Display Panels and Field Emission Displays.

**Example 12 (Comparative Example from Suess,** EP0589241**, Example 13)**

The individual components of the composition of Example 12, as detailed in the Suess patent, EP0589241, Example 13, were added to a milling apparatus containing Zirconia mill media and milled for 2.5 hours (with a slow roll time of 50 minutes). The composition was removed from the milling apparatus, cast, and dried overnight under a hood. The tape was much to sticky, causing unacceptable packaging, handling and processing problems (i.e., it stuck to itself in the stack, roll, phototool, etc). Also, Hot Roll Lamination (HRL) performance was poor. A layer of the tape formed from the composition of Example 12, was hot roll laminated at 85-110°C at 0.2 to 0.3 m/min, to the alumina substrate. Delamination at the edge of the coating was observed, in spite of the severe self-lamination tendency, also observed. Parts processed two times the normal HRL process still showed signs of poor lamination when exposed and developed. The tape was then exposed to actinic radiation through a patterned image for approximately 4 seconds. The exposed tape on alumina substrate was then developed at a development speed of 5 feet/minute (1.5 m/min) in an aqueous solution of 1% sodium carbonate at approximately 85°F (29°C). Post Exposure Bake was required to reduce the cracking / ripping seen after development. Edge curling seen after firing appears to be a combination of the poor lamination properties along with the tendency of this organic system to curl when heated.

### Example 13

In order to demonstrate the ease, speed and versatility of the PTOS technology, a layer of the tape formed from the composition of Example 3 (Tables 4-7) was hot roll laminated, with air assist activated, to a 4" X 6" (10-15 cm) 96% alumina substrate. The photosensitive tape was then exposed to actinic radiation through a patterned image formed by photocopying a digital photograph directly on to overhead media ("Mylar"). The image was exposed for approximately 4-10 seconds. The exposed tape on the alumina substrate was then developed in an aqueous base solution of 1% sodium carbonate at approximately 85°F (29°C) at a development speed of 2.0-3.0 ft/min (0.61-0.91 m/min). The substrate was then fired on a standard 60 minute firing profile in a conventional belt furnace. The fired substrate exhibited excellent reproduction of the original art work pattern.

Using this technology, it would be possible to create a fired image of an existing pattern (photograph, digitalized object, text, pattern, design, etc.) in 2-3 hours. The only limitation is that the pattern must limit exposure of the tape in the desired areas. For example, the image could be formed by simply marking the tape directly with an ink which is sufficient to block exposure in the marked areas. There is no existing technology that offers the ease, speed and versatility of the photo sensitive tape film compositions described in the present invention.

### Example 14

### Paste Formulation I:

Glass* 4.3%
Inorganic Oxide (Aluminium oxide)*** 3.5%
Titanium diboride 1.5%
Copper bismuth Ruthenate 0.8%
Palladium powder 3.5%
Silver Powder** 71.1%
Balance: Organic medium containing, resin, solvent, wetting agents

* Glass Characteristics:
   Alumino boro silicate glass containing cations such as:
      Ca, Mg, Ti, Na, K. Fe and gives a softening point ~820-840°C (log viscosity 7.6) and at 910-925°C (Log viscosity 6) provided from Nippon Electric Gas Co. (E-glass such as EF/F005).
   ** Metal powders are spherical, flake, irregular or combinations
   *** Inorganic Oxide Characteristics
      Refractory oxides such as Al₂O₃, ZrO₂ act as "sintering inhibitors"

Thick Film Composition "Paste" Making: Pastes (for both Examples 13 and 14) were formed using standard thick film techniques. All ingredients were thoroughly mixed in a mixer on a three roll mill or both in order to achieve appropriate dispersion. Once the metals and oxides were suitably dispersed, the paste was formulated to the proper solids and viscosity levels through the addition of solvent or resin containing organic vehicle. The solids level was also chosen for good screen printability, as well as for optimal functional performance (adhesion, resistivity, electrical contact, etc). First the inorganic components were (a) dispersed in organic medium containing polymers such as ethyl cellulose and /or hydroxy ethyl cellulose dissolved in texanol or, terpineol, phthaltes, wetting agents such as soya lecithin. Next, the thick film composition was (b) roll-milled using the thick film formulation techniques to a viscosity of 80 - 250 PaS or higher as measured in viscometer 2xHA UC & SP at 10 RPM.

### Example 15

### Paste Formulation II

Glass* 1.2%
Titanium diboride 1.2%
Palladium powder 4%
Silver powder** 82.7%
Balance: Organic medium containing resin, solvent wetting agents

* Glass Characteristics:
   Alumino boro silicate glass containing cations such as:
      Ca, Mg, Ti, Na, K. Fe and gives a softening point ~820-840°C (log viscosity 7.6) and at 910-925°C (Log viscosity 6) and provided from Nippon Electric Gas Co. (E-glass such as EF/F005).
   ** Metal powders are spherical, flake, irregular or combinations
   *** Inorganic Oxide Characteristics
      Refractory oxides such as Al₂O₃, ZrO₂ act as "sintering inhibitors"

The thick film via fill composition was printed onto the PTOS film (as identified in Examples above) and fired. Results for Examples 13 and 14 are detailed below. Additionally, Figure 1 details both the repeated firing effect and effect of the thermal cycle intervals versus resistivity characteristics for PTOS parts which utilize the thick film via fill composition of the present invention and other commercially available conductor compositions (Product Nos. QM18 and QS300 commercially available from E. I. du Pont de Nemours and Company, Product No. 1198 commercially available from Delphi Electronics)

Microstructures of the fired via fill composition in composition with different line conductors showed: (1) good bonding between the line conductor and via-fill conductor. (2) little or no porosity (3) excellent "side bonding" with ceramic and via-fill conductor.

In few cases, a tiny void was noticed closer to the via-fill and ceramic interface but always in the ceramic film. The fired parts were subjected to (1) repeated refiring up to 15 times measuring resistivity after each firing and (2) then the circuits were subjected to thermal cycle reliability tests up to 1000 cycles and each cycle consisted of 2 hours between the temperatures of -40 °C to +125 °C measuring resistivity, intermittently.

In Figure 1, 85B/QM18, the QM18 conductor was used as both the innerlayer and bottom conductor. In Figure 1 85B/QM18/1198, QM18 was used as the innerlayer conductor and 1198 was the bottom conductor. In Figure 1, 85B/QS300, the QQ300 conductor was used as both the innerlayer and bottom conductor. In Figure 1, 85B/QS300/1198, QS300 was used as the innerlayer conductor and 1198 was the bottom conductor.

The results in Figure 1 showed little or no property degradation as evaluated using resistivity measurements in combination with several line conductors. The test pattern contains over ~300 vias and ~5100 squares of conductor lines in series. Any separation of one via from the line conductor during refiring or thermal cycle would result in an infinite resistance, which was not observed. Combination test (15 refiring & 1000 thermal cycle) proved the reliability of the circuit during and after the test.

## Claims

1. A thick film conductor composition comprising:
(a) 70 to 98 weight percent of one or more electrically functional powders;
(b) 0.5 to 10 weight percent glass frit;
(c) 0.5 to 6 weight percent inorganic borides; dispersed in
(d) organic medium, wherein the weight percentages are based on the total thick film composition.

2. The composition of claim 1 further comprising one or more refractory inorganic oxides.

3. Photosensitive tape comprising the composition of claim 1.

4. An electronic circuit formed from the composition of claim 1 wherein said composition has been fired to volatilize the organic medium and sinter the glass frit.

5. A method of forming an electronic circuit comprising the steps of:
(a) providing a dimensionally stable substrate;
(b) providing the conformable photosensitive green dielectric tape;
(c) hot roll laminating the photosensitive green tape of (b) to the substrate of (a);
(d) exposing the photosensitive green tape of (c) in a desired pattern thus creating polymerized and unpolymerized areas;
(e) developing the unexposed film of (d) thus removing the unpolymerized areas and forming a patterned film comprising a desired pattern of vias and polymerized areas; and
(f) depositing the composition of claim 1 onto desired areas of said patterned film.

6. The method of claim 5 wherein said desired areas of said patterned film is in one or more of said vias.

7. An electronic circuit obtainable by the method of claim 6.

8. A structure comprising a dimensionally stable substrate, at least one layer formed from a castable photosensitive dielectric composition, and at least one layer formed from the composition of claim 1 wherein said castable photosensitive dielectric composition and the composition of claim 1 have been processed to volatilize the organic medium and sinter the glass frit.

9. A structure comprising a dimensionally stable substrate, at least one layer formed from conformable green dielectric tape, and at least one layer formed from the composition of claim 1 wherein said composition of claim 1 and said tape have been processed to volatilize the organic medium and sinter the glass frit.

10. The structure of claim 9 wherein said structure further comprises one or more metallization layers.
